(19) Europäisches Patentamt
European Patent Office
Office européen des brevets

(11) Veröffentlichungsnummer : **0 454 669 B1**

(12) **EUROPÄISCHE PATENTSCHRIFT**

(45) Veröffentlichungstag der Patentschrift :
30.09.92 Patentblatt 92/40

(51) Int. Cl.$^5$ : **H01H 9/04**, H05K 5/02

(21) Anmeldenummer : **89905068.6**

(22) Anmeldetag : **27.04.89**

(86) Internationale Anmeldenummer :
**PCT/DE89/00268**

(87) Internationale Veröffentlichungsnummer :
**WO 90/08393 26.07.90 Gazette 90/17**

(54) **GEHÄUSE FÜR EIN ELEKTROMECHANISCHES BAUELEMENT, INSBESONDERE FÜR EIN RELAIS.**

(30) Priorität : **17.01.89 DE 8900466 U**

(43) Veröffentlichungstag der Anmeldung :
**06.11.91 Patentblatt 91/45**

(45) Bekanntmachung des Hinweises auf die
Patenterteilung :
**30.09.92 Patentblatt 92/40**

(84) Benannte Vertragsstaaten :
**AT BE CH DE FR GB IT LI NL SE**

(56) Entgegenhaltungen :
**DE-B- 1 233 931**
**DE-U- 8 017 121**
**DE-U- 8 703 079**

(73) Patentinhaber : **Siemens Aktiengesellschaft**
**Postfach 22 16 34**
**W-8000 München 2 (DE)**

(72) Erfinder : **MÜLLER, Erwin**
**Engadinerstrasse 6 IV**
**W-8000 München 71 (DE)**

EP 0 454 669 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Gehäuse für ein elektromechanisches Bauelement insbesondere für ein Relais

Die Erfindung betrifft ein Gehäuse für ein elektromechanisches Bauelement, insbesondere für ein Relais, mit einer einen gasgefüllten Innenraum dicht abschließenden Gehäusewand, wobei die Gehäusewand einen abtrennbaren Vorsprung nach außen bildet, in den sich von dem Innenraum her ein Kanal erstreckt.

Bei elektromechanischen Bauelementen, wie Relais, besteht vielfach die Forderung, daß sie zum Einlöten auf Leiterplatten dicht sein müssen, um das Eindringen von flüssigen Reinigungsund Lötmitteln sowie von Dämpfen zu vermeiden. Zu diesem Zweck wird das Gehäuse üblicherweise auf der Anschlußseite mit Vergußmasse verschlossen, wodurch die Durchführungen für die Anschlußstifte und die Spalte zwischen Sockel und Kappe verschlossen werden. Es hat sich aber als zweckmäßig herausgestellt, solche Gehäuse mit Kunststoffkapselung nach dem Einlöten für den weiteren Einsatz wieder mit einer Belüftungsöffnung zu versehen, um im Gehäuseinneren die Entstehung eines kontaktschädigenden Kleinklimas zu verhindern. Dieses Kleinklima wird beispielsweise durch unzureichende Wärmeabfuhr beim Schalten größerer Ströme beeinflußt.

Zu diesem Zweck ist es beispielsweise aus dem DE-U-80 17 121 bekannt, an einer Gehäusekappe eines Relais einen Vorsprung in Form eines hohlen Kegels oder Zylinders anzuformen. Dieser Vorsprung wird nach dem Einlöten des Relais mittels eines Werkzeugs abgetrennt, wodurch der vom Gehäuseinneren sich in den Vorsprung erstreckende Kanal freigelegt wird. Der Querschnitt der Belüftungsöffnung ist durch den Kanalquerschnitt an der festgelegten Abtrennstelle vorgegeben. Wenn also das Relais für verschiedene Einsatzzwecke und verschiedene Schaltbelastungen eine unterschiedliche Belüftung erfahren soll, muß dies von vorneherein durch unterschiedliche Gehäusekappen mit entsprechend unterschiedlich geformten Vorsprüngen berücksichtigt werden.

Bei Bauelementen, wie Relais, mit einem großen Gasvolumen im Gehäuse besteht andererseits das Problem, das beim Abdichten des Gehäuses mit warmer Vergußmasse und beim Aushärten dieser Vergußmasse ein Überdruck entsteht, der entweder zu Poren an den Abdichtstellen führen oder eine Ausbauchung der Gehäusekappe verursachen kann. Zur Vermeidung dieses Effektes ist es auch bereits bekannt, ein Entlüftungsloch für den Hauptabdichtvorgang im Gehäuse vorzusehen, welches nachträglich durch thermische Verformung oder durch Aufbringen eines Harztropfens verschlossen wird, falls zum Einlöten oder auch für den späteren Einsatz ein vollständiger Abschluß des Gehäuses gewünscht wird. Solche verschließbaren Entlüftungslöcher, die auch in einem Zapfen untergebracht sein können, wurden bisher jeweils in anderer Form und unabhängig von den oben erwähnten hohlen Gehäusevorsprüngen zum nachträglichen Belüften vorgesehen.

Aufgabe der Erfindung ist es, ein Gehäuse für ein elektromechanisches Bauelement, insbesondere für ein Relais, zu schaffen, bei dem ein mit einem Belüftungskanal versehener Gehäusevorsprung in einer einzigen Ausführung sowohl für eine Entlüftung beim Abdichten als auch für eine Belüftung nach dem Einlöten verwendet werden kann, wobei das Maß der Belüftung entsprechend dem Einsatzzweck und der Schaltbelastung auch unterschiedlich gewählt werden kann.

Erfindungsgemäß wird diese Aufgabe bei einem Gehäuse der eingangs genannten Art dadurch gelöst, daß der Kanal in dem Vorsprung mindestens zwei Abschnitte mit unterschiedlichen, von innen nach außen stufenförmig kleiner werdenden Querschnitten besitzt. Der äußere, einen geringeren Querschnitt aufweisende Abschnitt des Kanals kann dabei eine ganz oder teilweise geschlossene Querwand, etwa in Form einer Spritzhaut, aufweisen. Diese Querwand kann in bekannter Weise am Ende des Vorsprungs als Abschlußwand vorgesehen sein, sie kann aber auch etwa auf mittlerer Höhe des äußeren, einen geringeren Querschnitt aufweisenden Kanalabschnittes vorgesehen sein. Dies ist besonders dann von Vorteil, wenn die Querwand ein kleines Entlüftungsloch für den Hauptabdichtvorgang des Gehäuses besitzt, welches nachträglich verschlossen werden soll. Die das Entlüftungsloch aufweisende Querwand bildet in diesem Fall mit dem nach außen offenen Teil des betreffenden Kanalabschnitts eine Auftropfwanne, in die ein Harztropfen zum nachträglichen Abdichten des Entlüftungsloches eingebracht werden kann. Da sich dieser Kanalabschnitt an der Innenseite der Querwand wiederum erweitert, bildet er eine Kapillarsperre, die ein Hineinfließen des Harztropfens in das Gehäuseinnere verhindert.

Der Vorsprung des Gehäuses ist zweckmäßigerweise auch mit seinen Außenkonturen an den abgestuften Querschnitt des innenliegenden Kanals angepaßt. Damit ist auch von außen erkennbar, wo der kleinere Kanalquerschnitt beginnt. Somit kann man leicht erkennen, wo der Vorsprung abzutrennen ist, um entweder ein großes oder ein kleines Belüftungsloch freizulegen. Der Vorsprung kann dabei die Form eines gestuften Zapfens besitzen, welcher in einem stufenförmig zurückgesetzten Gehäuseteil vorgesehen ist, so daß der Zapfen nicht über die generelle Gehäusekontur vorsteht. Der Vorsprung kann aber auch in Form einer abgestuft ausgebildeten Rippe, etwa in Weiterbildung der in dem DE-U-87 03 079 gezeigten Rippe an einer Gehäuseecke, vorgesehen werden.

Die Erfindung wird nachfolgend an einem Ausführungsbeispiel anhand der Zeichnung näher erläutert. Es zeigen

FIG 1 ein quaderförmiges Relaisgehäuse mit einem Vorsprung in Form eines gestuft ausgebildeten Zapfens,

FIG 2 einen vergrößerten Querschnitt durch den Zapfen von FIG 1,

FIG 3 eine vergrößerte Draufsicht auf den Zapfen von FIG 1.

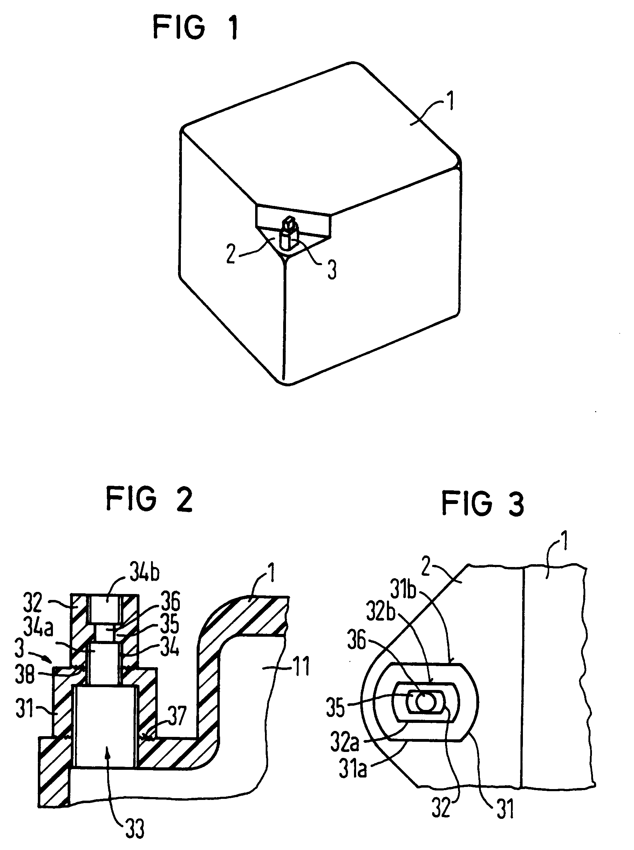

Das in FIG 1 gezeigte Relaisgehäuse besteht im wesentlichen aus einer Kappe 1, welche auf einen nicht sichtbaren Grundkörper, etwa einen Sockel, aufgesetzt wird. In diesem Grundkörper können beispielsweise Anschlußstifte nach unten austreten. Die Durchführungen der Anschlußstifte und die Spalte zwischen der Kappe und dem Grundkörper werden in bekannter Weise abgedichtet, was hier nicht näher gezeigt und beschrieben zu werden braucht.

Die Kappe 1 besitzt an einer ihrer oberen Ecken eine zurückgesetzte Stufe 2, auf der ein Vorsprung in Form eines abgestuften Zapfens 3 so angeordnet ist, daß er nicht über die Quaderkontur des Gehäuses 1 vorsteht.

Die spezielle Gestaltung des Zapfens 3 ist in der Schnittdarstellung von FIG 2 und in der Draufsicht von FIG 3 zu sehen. Demnach ist der Zapfen 3 sowohl innen als auch außen abgestuft ausgebildet, so daß ein erster Abschnitt 31 mit größerem Querschnitt und ein zweiter Abschnitt 32 mit kleinerem Querschnitt gebildet sind, wobei der Abschnitt 31 unmittelbar auf der Stufe 2 des Gehäuses 1 sitzt, während der Abschnitt 32 das freie Ende des Zapfens 3 bildet. Natürlich könnten bei Bedarf auch zusätzliche Abstufungen vorgesehen sein.

Der Zapfen 3 ist innen hohl und bildet so einen Lüftungskanal, der mit dem Gehäuseinnenraum 11 in Verbindung steht. Im Bereich des Abschnitts 31 des Zapfens liegt ein Kanalabschnitt 33 mit großem Querschnitt, während im Bereich des Zapfenabschnitts 32 ein Kanalabschnitt 34 mit ebenfalls verkleinertem Querschnitt liegt. Der Kanalabschnitt 34 ist außerdem durch eine Querwand 35, die als Spritzhaut ausgebildet sein kann, in zwei Teilabschnitte 34a und 34b unterteilt, wobei die Querwand 35 im vorliegenden Beispiel wiederum zentrisch ein Lüftungsloch 36 besitzt. Je nach Anwendungsfall kann dieses Lüftungsloch 36 von Anfang an in der Querwand 34 vorgesehen werden oder später durchgestochen werden. Es dient in der Regel dazu, während der Abdichtung des Gehäuses 1 mit Vergußmasse einen Druckausgleich zu ermöglichen. Soll dieses Lüftungsloch 36 später verschlossen werden, so kann beispielsweise ein Harztropfen in den Teilabschnitt 34b von oben eingebracht werden, der damit als Auftropfwanne dient. Die Erweiterung des Kanalquerschnitts unterhalb der Querwand 35 wirkt als Kapillarsperre, so daß der Harztropfen nicht in den Teilabschnitt 34a oder weiter in das Gehäuse eindringt.

Soll das Gehäuse etwa nach dem Einlöten des Bauelementes auf einer Leiterplatte belüftet werden, so kann je nach Befarf entweder der Abschnitt 32 oder der ganze Zapfen mit den Abschnitten 31 und 32 entfernt werden. Dies kann beispielsweise dadurch geschehen, daß der betreffende Zapfenabschnitt mittels eines Werkzeuges verdreht wird und dann an der Bruchfläche 37 oder an der Bruchfläche 38 abbricht. Entsprechend wird eine Belüftungsöffnung mit dem Querschnitt des Kanalabschnitts 34 oder mit dem Querschnitt des Kanalabschnitts 32 geöffnet.

In FIG 3 sind die Konturen des Zapfens 3 von oben gesehen gezeigt. In dem vorliegenden Beispiel sind die Zylinder-Querschnitte an den gegenüberliegenden Seiten 31a und 31b bzw. 32a und 32b abgeflacht. Damit lassen sich die Zapfen leichter mit einer Zange oder einem Steckschlüssel erfassen und durch Drehen abscheren.

Die Kanalabschnitte in dem Zapfen 3 können rund, langlochförmig oder eckig ausgeführt sein. Die gezeigte Ausbildung im oberen Teil ermöglicht einerseits eine Stempelabstützung in der Spritzgießform und somit eine höhere Standzeit und Festigkeit dieser Form, andererseits ergibt die mittig liegende Querwand 35 eine Versteifung, was das beschriebene Abscheren des Zapfens erleichtert.

Der stufenförmige Vorsprung kann natürlich auch jede andere Form aufweisen und an anderen Stellen des Gehäuses angebracht sein. Beispielsweise wäre es denkbar, anstelle der Stufe 2 im Gehäuse eine Abschrägung entsprechend DE-U-87 03 079 vorzusehen und den Vorsprung als Zapfen oder als abgestufte Rippe auf dieser Abschrägung auszubilden.

## Patentansprüche

1. Gehäuse für ein elektromechanisches Bauelement mit einer einen gasgefüllten Innenraum dicht abschließenden Gehäusewand, wobei die Gehäusewand einen abtrennbaren Vorsprung nach außen bildet, in den sich von dem Innenraum her ein Kanal erstreckt, **dadurch gekennzeichnet**, daß der Kanal (33, 34) in dem Vorsprung (3) mindestens zwei Abschnitte (33, 34) mit unterschiedlichen, von innen nach außen stufenförmig kleiner werdenden Querschnitten besitzt.

2. Gehäuse nach Anspruch 1, **dadurch gekennzeichnet**, daß in dem äußeren, einen geringeren Querschnitt aufweisenden Abschnitt (34) des Kanals eine ganz oder teilweise geschlossene Querwand (35) vorgesehen ist.

3. Gehäuse nach Anspruch 2, **dadurch gekennzeichnet**, daß die Querwand (35) etwa auf mittlerer Höhe des äußeren Kanalabschnittes (34) vorgesehen ist.

4. Gehäuse nach Anspruch 3, **dadurch gekennzeichnet,** daß die Querwand ein Lüftungsloch (36) aufweist.

5. Gehäuse nach einem der Ansprüche 1 bis 4, **dadurch gekennzeichnet**, daß die Außenkontur des Vorsprungs (3) in Anpassung an den Querschnitt des Kanals (33, 34) ebenfalls eine abgestufte Form besitzt.

6. Gehäuse nach einem der Ansprüche 1 bis 5, **dadurch gekennzeichnet**, daß der Vorsprung (3) in Form eines Zapfens (3) auf einem stufenförmig zurückgesetzten Gehäuseteil (2) vorgesehen ist.

7. Gehäuse nach Anspruch 6, **dadurch gekennzeichnet**, daß der abgestuft ausgebildete Zapfen (3) in jedem Abschnitt eine Außenkontur in Form eines an zwei gegenüberliegenden Seiten (31a, 31b, 32a, 32b) abgeflachten Zylinders aufweist.

8. Gehäuse nach einem der Ansprüche 1 bis 4, **dadurch gekennzeichnet**, daß der Vorsprung in Form einer abgestuften Rippe an einer Gehäuseecke vorgesehen ist.

## Claims

1. Housing for an electromechanical component having a housing wall which closes a gas-filled internal space in a sealed manner, the housing wall forming a separable external projection in which a channel extends from the internal space, characterised in that the channel (33, 34) in the projection (3) has at least two sections (33, 34) with different cross-sections which become smaller from the inside to the outside in a stepped manner.

2. Housing according to Claim 1, characterised in that a completely or partially closed lateral wall (35) is provided in the outer section (34) of the channel which has a smaller cross-section.

3. Housing according to Claim 2, characterised in that the lateral wall (35) is provided approximately at the mean height of the outer channel section (34).

4. Housing according to Claim 3, characterised in that lateral wall has a ventilation hole (36).

5. Housing according to one of Claims 1 to 4, characterised in that the outer contour of the projection (3) likewise has a stepped shape, matched to the cross-section of the channel (33, 34).

6. Housing according to one of Claims 1 to 5, characterised in that the projection (3) is provided in the form of a pin (3) on a housing part (2) which is set back in a stepped manner.

7. Housing according to Claim 6, characterised in that the pin (3), which is of stepped construction, has an outer contour in each section in the form of a cylinder which is flattened on two opposite sides (31a, 31b, 32a, 32b).

8. Housing according to one of Claims 1 to 4, characterised in that the projection is provided in the form of a stepped rib on a housing corner.

## Revendications

1. Boîtier pour un composant électromécanique comportant une paroi fermant de façon étanche un espace intérieur rempli de gaz, la paroi du boîtier formant un appendice saillant séparable dirigée vers l'extérieur et dans lequel un canal s'étend à partir de l'espace intérieur, caractérisé par le fait que le canal (33,34) situé dans l'appendice saillant (3) possède au moins deux parties (33,34) ayant des sections transversales différentes, dont la taille diminue en paliers de l'intérieur vers l'extérieur.

2. Boîtier suivant la revendication 1, caractérisé par le fait qu'une paroi transversale (35) totalement ou partiellement fermée est prévue dans la partie extérieure (34), qui possède une section transversale réduite, du canal.

3. Boîtier suivant la revendication 2, caractérisé par le fait que la paroi transversale (35) est prévue approximativement à mi-hauteur de la partie extérieure (34) du canal.

4. Boîtier suivant la revendication 3, caractérisé par le fait que la paroi transversale comporte un trou d'aération (36).

5. Boîtier suivant l'une des revendications 1 à 4, caractérisé par le fait que le contour extérieur de l'appendice saillant (3) possède également une forme étagée, d'une manière adaptée à la section transversale du canal (33, 34) .

6. Boîtier suivant l'une des revendications 1 à 5, caractérisé par le fait que la partie saillante (3) est, réalisée sous la forme d'un embout (3) sur une partie en palier et en retrait (2) du boîtier.

7. Boîtier suivant la revendication 6, caractérisé par le fait que l'embout de forme étagée (3) possède, dans chaque section, un contour extérieur ayant la forme d'un cylindre, aplati sur deux faces opposées (31a,31b,32a,32b).

8. Boîtier suivant l'une des revendications 1 à 4, caractérisé par le fait que l'appendice saillant est réalisé sous la forme d'une nervure étagée au niveau d'un coin du boîtier.

# FIG 1

# FIG 2

# FIG 3